# EUROPEAN PATENT APPLICATION

(11) **EP 4 561 323 A1**
(43) Date of publication of application: **28.05.2025**
(21) Application number: 24201429.8
(22) Date of filing: 19.09.2024
(51) Int. Cl.: H10K 59/80, H10K 77/10, H10K 59/40, H10K 102/00

(54) **DISPLAY APPARATUS**

(30) Priority: 22.11.2023 KR 20230163684
(71) Applicant: LG Display Co., Ltd., Seoul 07336 (KR)
(72) Inventor: Lee, Junjae, 10845 Paju-si (KR)
(74) Representative: Ter Meer Steinmeister & Partner

(57) **Abstract**

Disclosed is a display apparatus. The display apparatus includes a substrate which includes a first non-bending area, a second non-bending area, and a bending area disposed between the first non-bending area and the second non-bending area. The display device further includes a transistor and a light emitting diode layer disposed in the first non-bending area on the substrate. The display device further includes a cover layer which is disposed in the first non-bending area, the second non-bending area, and the bending area on the substrate. The display device further includes a partition disposed in the second non-bending area on the substrate.

## Description

The present disclosure relates to a display apparatus, and more particularly, for example, without limitation, to a display apparatus which improves a crack and a moisture permeation problem by disposing a cover layer and a partition.

### Description of the Related Art

A recent display apparatus which is capable of displaying various information and interacting with a user who watches the information is required to have various sizes, various shapes, and various functions.

Examples of the display apparatus include a liquid crystal display apparatus (LCD), an electrophoretic display apparatus (FPD), a field emission display apparatus(FED), an organic light-emitting display apparatus (OLED) and an inorganic light emitting diode display apparatus (LED).

As the display apparatus is utilized in various ways, the design of the display apparatus is becoming more diverse in order to reduce the area of the non-active area where images are not displayed for the aesthetic sensibility of users. A high ratio of the size of the luminous active area to the size of the non-active area is one of the most important design challenges. All or a part of the non-active area is folded to be disposed on a rear surface of the active area so that the non-active area is hidden to the users. Therefore, a display apparatus with an increased ratio of the active area which is visible to the users is provided.

In order to provide a display apparatus with an increased ratio of the active area which is visible to the users, the substrate is curved so that a part of the substrate has a curved area (or a bending area).

The description provided in the description of the related art section should not be assumed to be prior art merely because it is mentioned in or associated with the description of the related art section. The description of the related art section may include information that describes one or more aspects of the subject technology, and the description in this section does not limit the invention.

### SUMMARY

The inventors have recognized that, in the display apparatus, a wiring line disposed in the bending area may be cracked due to a mechanical stress applied to the curved area (or the bending area), and the crack can cause external moisture or oxygen to penetrate, causing problems such as electrolytic corrosion or corrosion of the wiring line, which can interfere with image operation and cause abnormal image display problems.

Thus, it is an object to prevent and cracks in the wiring line in the bending area.

Accordingly, an object to provide a display apparatus which includes a cover layer and a partition to remove a crack and a short-circuit of a wiring line generated in a bending area which is formed during a bending process of a substrate or after a bending process, due to a mechanical stress.

Another object is to provide a display apparatus in which a cover layer is disposed in a bending area and overlaps a wiring line disposed in the bending area to remove a crack and a short-circuit of a wiring line in the bending area.

The object is solved by the features of the independent claims. Preferred embodiments are given in the dependent claims.

According to an aspect of the present disclosure, a display apparatus includes: a substrate which includes a first non-bending area, a second non-bending area, and a bending area disposed between the first non-bending area and the second non-bending area; a transistor and a light emitting diode layer disposed in the first non-bending area on the substrate; a cover layer which is disposed in the first non-bending area, the second non-bending area, and the bending area; and a partition disposed in the second non-bending area.

In another aspect of the disclosure a display apparatus is provided, comprising: a substrate which includes a first non-bending area, a second non-bending area, and a bending area disposed between the first non-bending area and the second non-bending area; a light emitting element layer disposed in the first non-bending area on the substrate; a cover layer which is disposed in the first non-bending area, the bending area on the substrate, and a partial area of the second non-bending area, the cover layer being disposed over the light emitting element layer; and a partition disposed in the second non-bending area on the substrate.

In one or more embodiments, the partition may include a first partition and a second partition spaced from each other.

In one or more embodiments, the cover layer may be disposed in a partial area of the second non-bending area close to the bending area.

In one or more embodiments, the cover layer may be not disposed in other areas of the second non-bending area excluding the partial area.

In one or more embodiments, the cover layer may be continuously disposed in the first non-bending area, the second non-bending area, and the bending area.

In one or more embodiments, the cover layer may be in contact with one surface of the partition.

In one or more embodiments, the display apparatus may further comprise a touch unit disposed over the light emitting diode layer; and a protection layer disposed on the touch unit.

In one or more embodiments, the cover layer may be disposed on the protection layer.

In one or more embodiments, the touch unit may include a touch line.

In one or more embodiments, the cover layer may be in contact with the touch line in the second non-bending area.

In one or more embodiments, the display apparatus may further comprise a second protection layer disposed between the transistor and the light emitting diode layer,

In one or more embodiments, the second protection layer may include a first sub protection layer and a second sub protection layer.

In one or more embodiments, a connection line connecting to the touch line may be disposed between the first sub protection layer and the second sub protection layer.

In one or more embodiments, an end of the cover layer in the second non-bending area may be disposed between the protection layer and the partition.

In one or more embodiments, the partition may be configured on the same layer as the protection layer.

In one or more embodiments, the display apparatus may further comprise a dam disposed on the first non-bending area.

In one or more embodiments, the partition may be spaced apart from the dam by the bending area, i.e the bending area is between the partition and the dam.

In one or more embodiments, the display apparatus may further comprise a second protection layer and a bank disposed between the transistor and the light emitting diode layer; and a spacer disposed on the bank.

In one or more embodiments, the dam may be configured with the same material as at least one or more of materials which configure the spacer, the bank, and the protection layer.

In one or more embodiments, the cover layer may be in contact with the second protection layer in the bending area.

According to the exemplary embodiment of the present disclosure, the display apparatus includes a cover layer and a partition to suppress a crack and a short-circuit of a wiring line generated in a bending area which is formed during a bending process of a substrate or after a bending process, due to a mechanical stress.

According to the exemplary embodiment of the present disclosure, the display apparatus includes a cover layer which is disposed in a bending area and overlaps the wiring line disposed in the bending area to suppress a crack and a short-circuit of a wiring line generated in a bending area which is formed during a bending process of a substrate or after a bending process, due to a mechanical stress.

According to the exemplary embodiment of the present disclosure, in the display apparatus, a cover layer disposed in the active area extends to a bending area so that there is no need to place a separate protective member in the bending area. Therefore, the number of processes for manufacturing the display apparatus and a cost may be reduced.

According to the exemplary embodiment of the present disclosure, in the display apparatus, the wiring line is not cracked and shorted so that the display apparatus is normally driven to provide an improved aesthetic sensibility, lifespan, and reliability and reduce power consumption and/or a power.

The effects of the present disclosure are not limited to the aforementioned effects, and other effects, which are not mentioned above, will be apparently understood to a person having ordinary skill in the art from the following description.

The objects to be achieved by the present disclosure, the means for achieving the objects, and the effects of the present disclosure described above do not specify essential features of the claims, and, thus, the scope of the claims is not limited to the disclosure of the present disclosure.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 is a view illustrating a display apparatus according to an exemplary embodiment of the present disclosure;
FIG. 2 is a plan view of a display panel according to an exemplary embodiment of the present disclosure;
FIG. 3 is a cross-sectional view taken along the line I-I' of FIG. 2 according to an exemplary embodiment of the present disclosure;
FIG. 4 is a cross-sectional view of a display apparatus according to an exemplary embodiment of the present disclosure;
FIG. 5 is a plan view illustrating a display driver of a display panel according to an exemplary embodiment of the present disclosure;
FIG. 6 is a view illustrating placement of an emitting unit and a non-emitting unit of a display apparatus according to an exemplary embodiment of the present disclosure;
FIG. 7 is a cross-sectional view taken along the line II-II' of FIG. 6 according to an exemplary embodiment of the present disclosure; and
FIG. 8 is a cross-sectional view taken along the line III-III' of FIG. 5 according to an exemplary embodiment of the present disclosure.

Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION OF THE EMBODIMENT

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure.

The shapes, sizes, dimensions (e.g., length, width, height, thickness, radius, diameter, area, etc.), ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "include," "have," "comprise," "contain," "constitute," "make up of," "formed of," and "consist of' used herein are generally intended to allow other components to be added unless the terms are used with the term "only". Any references to singular may include plural unless expressly stated otherwise.

A dimension including size and a thickness of each component illustrated in the drawing are illustrated for convenience of description, and the present disclosure is not limited to the size and the thickness of the component illustrated, but it is to be noted that the relative dimensions including the relative size, location, and thickness of the components illustrated in various drawings submitted herewith are part of the present disclosure.

Components are interpreted to include an ordinary error range even if not expressly stated.

When the position relation between two parts is described using the terms such as "on", "above", "over", "below", "under", "beside", "beneath", "near", "close to," "adjacent to", "on a side of", "next", one or more parts may be positioned between the two parts unless the terms are used with the term "immediately" or "directly" is not used.

Spatially relative terms, such as "under," "below," "beneath", "lower," "over," "upper" and the like, may be used herein for ease of description to describe one element or feature's relationship to another element(s) or feature(s) as illustrated in the figures. It will be understood that the spatially relative terms can encompass different orientations of an element in use or operation in addition to the orientation depicted in the figures. For example, if an element in the figures is inverted, elements described as "below" or "beneath" other elements or features would then be oriented "over" the other elements or features. Thus, the exemplary term "below" can encompass both an orientation of below and above. Similarly, the exemplary term "above" or "over" can encompass both an orientation of "above" and "below".

When the relation of a time sequential order is described using the terms such as "after", "continuously to", "next to", and "before", the order may not be continuous unless the terms are used with the term "immediately" or "directly".

Although the terms "first", "second", "A", "B", "(a)", "(b)", and the like are used for describing various components, these components are not confined by these terms. These terms are merely used for distinguishing one component from the other components. Therefore, a first component to be mentioned below may be a second component in a technical concept of the present disclosure.

In describing components of the exemplary embodiment of the present disclosure, terminologies such as first, second, A, B, (a), (b), and the like may be used. These terminologies are used to distinguish a component from the other component, but a nature, an order, or the number of the components is not limited by the terminology. When a component is "linked", "coupled", or "connected" to another component, the component may be directly linked or connected to the other component. However, unless specifically stated otherwise, it should be understood that a third component may be interposed between the components which may be indirectly linked or connected.

It should be understood that "at least one" includes all combinations of one or more of associated components. For example, "at least one of first, second, and third components" means that not only a first, second, or third component, but also all combinations of two or more of first, second, and third components are included.

In the present specification, a "display apparatus" may include a display apparatus which includes a display panel and a driver for driving the display panel, in a narrow sense, such as a liquid crystal module (LCM), an organic light emitting module (OLED module), and a quantum dot module. Further, the "display apparatus" may further include a set electronic apparatus or a set apparatus (or a set device) which is a complete product or a final product including an LCM, an OLED module, a QD module, etc., such as a notebook computer, a television, or a computer monitor, an automotive display apparatus or equipment display apparatus including another type of vehicle and a mobile electronic apparatus including a smart phone or an electronic pad.

Accordingly, the display apparatus of the present disclosure may include not only a display apparatus itself in a narrow sense such as an LCM, an OLED module, a QD module, etc., but also an applied product or a set apparatus which is a final consumer device including the LCD, the OLED module, the QD module, etc.

Further, in some cases, the LCM, the OLED module, or the QD module which is configured by a display panel and a driver may be represented as "a display apparatus" in a narrow sense and an electronic device as a complete product including the LCM, the OLED module, and the QD module may be represented as a "set apparatus". For example, the display apparatus in the narrow sense includes a liquid crystal (LCD) display panel, an OLED display panel, or a quantum dot display panel and a source PCB which is a controller for driving the display panel. In contrast, the set apparatus may be a concept further including a set PCB which is a set controller which is electrically connected to the source PCB to control the entire set apparatus.

As a display panel used in the exemplary embodiment of the present disclosure, any type of display panel such as a liquid crystal display panel, an organic light emitting diode (OLED) display panel, a quantum dot (QD) display panel, and an electroluminescent display panel may be used. The display panel of the present exemplary embodiment is not limited to a specific display panel in which a bezel is bent with a flexible substrate for the organic light emitting diode (OLED) display panel and a back plate support structure therebelow. Further, a display panel used for the display apparatus according to the exemplary embodiment of the present disclosure is not limited to a shape or a size of the display panel.

The features of various exemplary embodiments of the present disclosure can be partially or entirely coupled to or combined with each other and can be interlocked and operated in technically various ways, and the exemplary embodiments can be carried out independently of or in association with each other.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein.

In the aspects of the present disclosure, a source electrode and a drain electrode are distinguished from each other, for convenience of description. However, the source electrode and the drain electrode are used interchangeably. The source electrode may be the drain electrode, and the drain electrode may be the source electrode. Also, the source electrode in any one aspect of the present disclosure may be the drain electrode in another aspect of the present disclosure, and the drain electrode in any one aspect of the present disclosure may be the source electrode in another aspect of the present disclosure.

Hereinafter, the exemplary embodiment of the present disclosure will be described with reference to the accompanying drawings and exemplary embodiments as follows. Scales of components illustrated in the accompanying drawings are different from the real scales for the purpose of description, so that the scales are not limited to those illustrated in the drawings.

Hereinafter, an exemplary embodiment of the present disclosure will be described in detail with reference to the drawings.

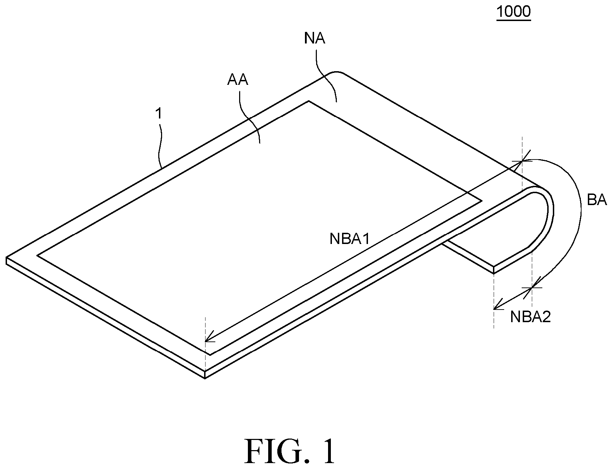

FIG. 1 is a view illustrating a display apparatus according to an exemplary embodiment of the present disclosure.

FIG. 1 is a view illustrating a state in which a display panel 1 of a display apparatus 1000 according to an exemplary embodiment of the present disclosure is bent.

The display panel 1 may include a bending area BA and a non-bending area NBA. The non-bending area NBA may include two or more areas according to an area of the substrate. For example, the substrate may have a bending area BA between two non-bending areas NBA.

The bending area BA is an area formed by bending a part of the display panel 1. Alternatively, the bending area BA is an area formed by bending a part of the substrate 110 included in the display panel 1. For example, the bending area is an area formed by bending a part of the substrate 110 to dispose a pad unit and an external module bonded to the pad unit on a rear surface of the substrate 110. For example, as the bending area BA is bent toward the rear surface of the substrate 110, the external module bonded to the pad unit of the substrate 110 moves to the rear surface of the substrate 110 and the external module may not be visible as seen from the top of the substrate 110. Further, as the bending area BA is bent, the size of the non-active area NA visible from the top of the substrate 110 is reduced so that a narrow bezel may be implemented.

The non-bending area NBA is an area in which a part of the substrate 110 is not bent to be flat. In the present disclosure, the non-bending area NBA may include two areas. For example, the non-bending area may include a first non-bending area NBA1 in which a plurality of sub pixels SP is disposed to display images and a second non-bending area NBA2 in which a pad connected or bonded to the flexible film 2 is disposed. However, the arrangement of the bending area BA and the non-bending area NBA is not limited thereto, for example, the non-bending area NBA may include three areas, the bending area BA may include two areas, the bending areas BA may be arranged between the non-bending areas NBA, but not limited thereto.

As shown in FIG. 1, the first non-bending area NBA1 and the second non-bending area NBA2 are bent by the bending area BA to be opposite to each other.

The display panel 1 may include an active area AA and a non-active area NA which fully or partially surrounds the active area AA. The non-active area NA may be adjacent to the active area AA and disposed at the outside from the active area AA.

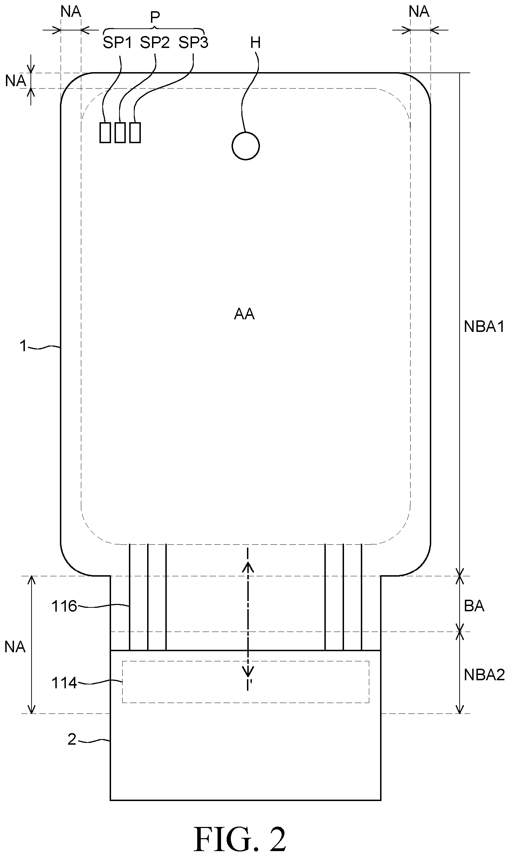

The active area AA may be an area where pixels P are disposed to display images. The non-active area NA is an area where no image is displayed and various wiring lines and driving circuits for driving the plurality of sub pixels SP disposed in the active area AA are disposed. The active area AA and the non-active area NA will be described in detail with reference to FIG. 2.

FIG. 2 is a plan view of a display panel according to an exemplary embodiment of the present disclosure.

Referring to FIG. 2, a display apparatus 1000 according to the exemplary embodiment of the present disclosure may include a display panel 1 and a flexible film 2.

The display panel 1 may be a panel which displays images. For example, the display panel 1 may use any type of display panel, such as a liquid crystal display panel, an organic light emitting diode (OLED) display panel, an inorganic light emitting diode (LED) display panel and an electroluminescent display panel, but the exemplary embodiment is not limited thereto.

The display panel 1 may include a substrate 110 disposed in a first non-bending area NBA1, a second non-bending area NBA2, and a bending area BA. The display panel 1 may include a substrate 110, a plurality of components disposed on the substrate, and a combination thereof. For example, the display panel 1 may include the substrate 110, a display driver DISP, an encapsulation unit 600, and a touch unit 700.

In some exemplary embodiments, the substrate 110 may be made of a flexible polymer film. For example, the flexible polymer film may be made of any one of polyimide (PI), polyethylene terephthalate (PET), acrylonitrile-butadiene-styrene copolymer(ABS), polymethyl methacrylate(PMMA), polyethylene naphthalate (PEN), polycarbonate (PC), polyethersulfone (PES), polyarylate (PAR), polysulfone (PSF), cyclic olefin copolymer(COC), triacetylcellulose(TAC), polyvinyl alcohol(PVA), and polystyrene(PS). However, the present disclosure is not limited thereto.

The flexible film 2 may electrically connect the display panel 1 to a printed circuit board which generates and outputs a pixel driving signal to the display panel 1.

Alternatively, the flexible film 2 may transmit a signal output from the printed circuit board to the display panel 1 and/or the printed circuit board.

The flexible film 2 may be formed of a material having flexibility and for example, may be formed of a plastic material, such as polyimide (PI).

The first non-bending area NBA1 of the display panel 1 may include an active area AA and a non-active area NA which surrounds the active area AA. The non-active area NA may be adjacent to the active area AA and may be disposed at the outside from the active area AA.

The active area AA may be an area where pixels P are disposed to display images. A plurality of sub pixels SPX is a minimum unit which configures the active area and n sub pixels SPX form one pixel. Each of the plurality of sub pixels SPX may emit light having different wavelengths from each other. The active area AA may include a plurality of sub pixels SP1, SP2, and SP3 or may include a plurality of sub pixels SP1, SP2, SP3 and SP4, and the plurality of sub pixels SP1, SP2, and SP3 or the plurality of sub pixels SP1, SP2, SP3 and SP4 includes a light emitting diode layer for displaying images and a thin film transistor for driving the light emitting diode layer. For example, the plurality of subpixels SPX may include red subpixels SPX, green subpixels SPX, and blue subpixels SPX. According to the exemplary embodiment, at least some of the plurality of pixels PX may further include white subpixels SPX. The plurality of subpixels SPX may be variously modified in colors and configurations, as necessary. However, the present disclosure is not limited thereto.

For example, the plurality of sub pixels SPX may include red, green, and blue sub-pixels, in which the red, green, and blue sub-pixels may be disposed in a repeated manner. Alternatively, the plurality of sub pixels SPX may include red, green, blue, and white sub-pixels, in which the red, green, blue, and white sub-pixels may be disposed in a repeated manner, or the red, green, blue, and white sub-pixels may be disposed in a quad type. For example, the red sub pixel, the blue sub pixel, and the green sub pixel may be sequentially disposed along a row direction, or the red sub pixel, the blue sub pixel, the green sub pixel and the white sub pixel may be sequentially disposed along the row direction. However, in the embodiment of the present disclosure, the color type, disposition type, and disposition order of the sub-pixels are not limiting, and may be configured in various forms according to light-emitting characteristics, device lifespans, and device specifications.

Meanwhile, the sub-pixels may have different light-emitting areas according to light-emitting characteristics. For example, a sub-pixel that emits light of a color different from that of a blue sub-pixel may have a different light-emitting area from that of the blue sub-pixel. For example, the red sub-pixel, the blue sub-pixel, and the green sub-pixel, or the red sub-pixel, the blue sub-pixel, the white sub-pixel, and the green sub-pixel may each has a different light-emitting area.

The non-active area NA may be an area where no image is displayed and various wiring lines and driving circuits for driving the plurality of sub pixels SP disposed in the active area AA are disposed. The non-active area NA does not display images so that a partial area of the non-active area NA may be bent to reduce the non-active area NA, for example, a bezel area.

A pad unit 114 may be disposed at one side of the second non-bending area NBA2 of the display panel 1. The pad unit 114 may be a metal pattern to which the external module, for example, a flexible printed circuit board (FPCB) and a chip on film (COF) are bonded. Even though it is illustrated that the pad unit 114 is disposed at one side of the display panel 1, a shape and a placement of the pad unit 114 are not limited thereto. For example, the pad unit 114 may be disposed at two sides of the display panel 1.

A connection line 116 may be disposed in a part of the non-active area NA. The connection line 116 may be disposed in the bending area BA of the display apparatus and the first non-bending area NBA1 and the second non-bending area NBA2 adjacent to the bending area BA.

The connection line 116 may be a configuration which transmits a signal (for example, a voltage) from the external module bonded to the pad unit 114 to the active area AA or a circuit unit such as the gate driver 112. For example, various signals and voltages, such as various gate signals, data signals, a high potential voltage, a low potential voltage and the like, may be transmitted through the connection line 116.

The connection line 116 may be classified into a power connection line and/or a signal connection line according to voltages and/or image signals to be transmitted.

The power connection line may transmit a voltage supplied from the external module to the active area AA. The power connection line may be connected to a low potential voltage line VSS, a high potential voltage line VDD, and a gate low voltage line and/or a gate high voltage line included in the gate driver, but is not limited thereto.

The signal connection line may transmit a signal supplied from the external module to the active area AA. The signal connection line may be connected to a scan line and/or a data line, but is not limited thereto.

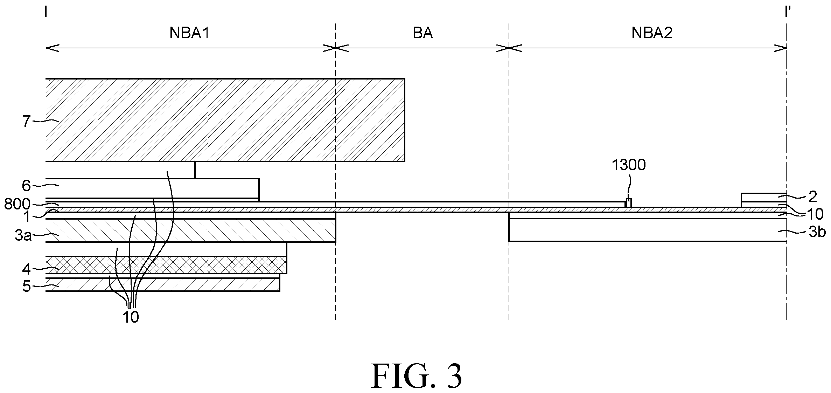

FIG. 3 is a view illustrating a display apparatus before being bent, according to an exemplary embodiment of the present disclosure. FIG. 3 is a cross-sectional view of a display apparatus corresponding to an area of the line I-I' of the display panel of FIG. 2.

Referring to FIG. 3, the display apparatus 1000 according to the exemplary embodiment of the present disclosure may include a display panel 1 and a cover layer 800.

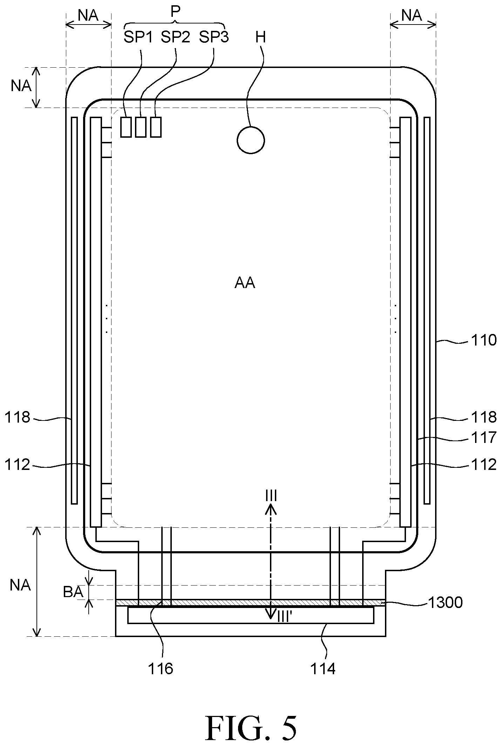

The display panel 1 may display images in the display apparatus. The display panel according to the present disclosure may include a light emitting diode display apparatus, however, present disclosure is not limited thereto. Components of the display panel 1 will be described below with reference to FIGS. 5 to 8.

A cover layer 800, a polarizer 6, and a flexible film 2 may be disposed on the display panel 1.

The cover layer 800 may be disposed in the first non-bending area NBA1 and the bending area BA. Additionally, the cover layer 800 may be disposed in a partial area of the second non-bending area NBA2 adjacent to the bending area BA.

The cover layer 800 may be formed to extend from the first non-bending area NBA1 to the bending area BA and the second non-bending area NBA2. For example, the cover layer 800 may be formed to extend from the first non-bending area NBA1 to the bending area BA and extends to a partial area of the second non-bending area NBA2, but the present disclosure is not limited thereto.

The cover layer 800 disposed in the first non-bending area NBA1 may additionally planarize an area in which components disposed below or under the cover layer 800 are not planarized. Furthermore, the cover layer 800 may effectively block moisture and oxygen entering from the outside of the display apparatus.

The cover layer 800 disposed in the bending area BA may suppress problems of a crack generated while bending the display panel 1 and permeation of external moisture. Additionally, the cover layer may suppress the short-circuit problem of the connection line 116 due to an external shock applied to the bending area BA after being bent or the problem of permeation of external moisture and/or oxygen into the display panel.

The cover layer 800 is disposed at least in a part of the second non-bending area NBA2 to suppress the problem in that the cover layer 800 is not applied in the bending area BA.

The cover layer 800 is disposed in the first non-bending area NBA1 and in the bending area BA and the process of bending the substrate 110 may be performed. The cover layer 800 disposed in the bending area BA may minimize the breakage of the display apparatus due to the crack which may be generated during the bending process.

The breakage of the display apparatus due to the external shocks may be minimized by the cover layer 800 even after the bending process and the crack and the separation of the display panel are blocked to normally transmit signals. Therefore, a display apparatus with an improved reliability and low power may be provided. Further, there is no need to place a separate protective member in the bending area BA so that the number of processes is reduced and the cost is saved.

A partition 1300 which controls the cover layer 800 may be disposed at one side of the second non-bending area NBA2. For example, the partition 1300 may be disposed in the second non-bending area NBA2. For example, the partition 1300 may be disposed at one side of the bending area BA and may be spaced apart from one side of the bending area BA. So, the partition is disposed at the outer side or edge of the second bending area.

The partition 1300 may be disposed along a periphery of at least one surface of the cover layer 800 to control the flow of the cover layer 800 which is configured with an organic material. The number of partitions 1300 may be one, two or plural and the exemplary embodiments of the present disclosure are not limited thereto.

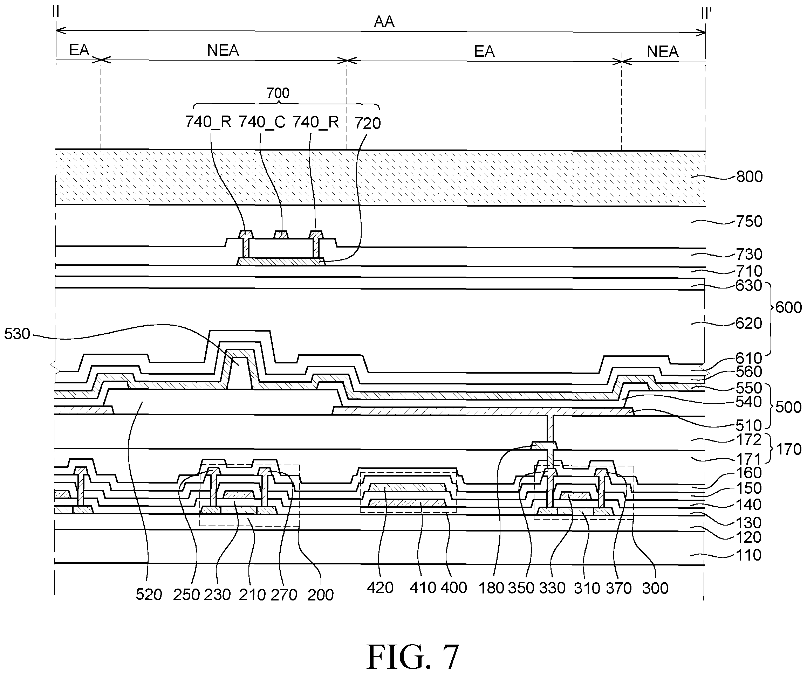

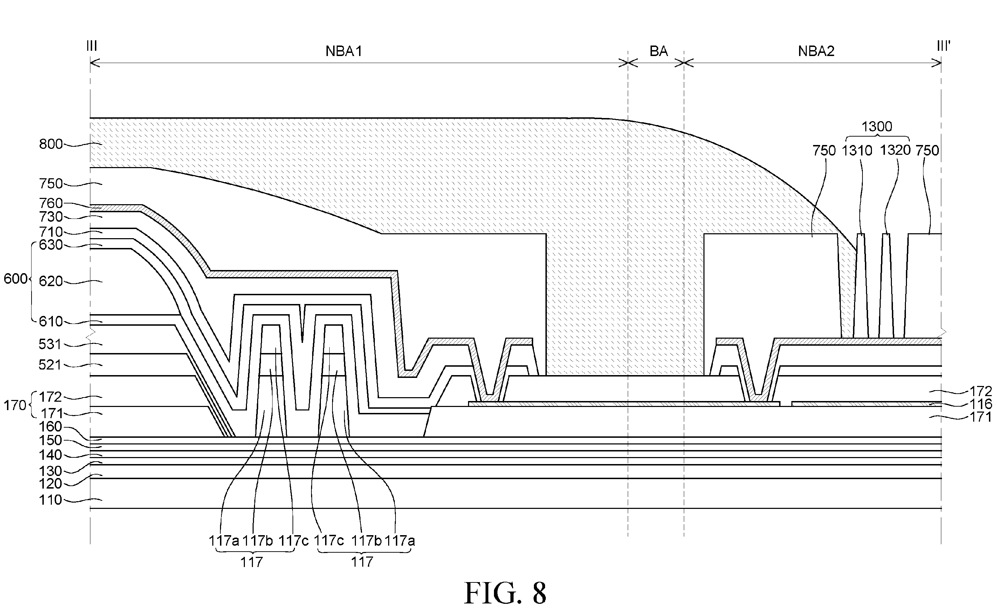

The configurations of the cover layer 800 and the partition 1300 will be described in detail with reference to FIGS. 7 and 8.

The flexible film 2 may be disposed in at least a part of the second non-bending area NBA2.

The flexible film 2 may be attached to the display panel 1 using an adhesive member 10. The adhesive member 10 may be formed of a material having adhesiveness and for example, may be formed of an optically clear adhesive (OCA) or a pressure sensitive adhesive (PSA), but is not limited thereto.

A polarizer 6 may be disposed on at least a part of the cover layer 800. The polarizer 6 may be disposed in the first non-bending area NBA1. For example, the polarizer 6 may be disposed in a partial area of the first non-bending area NBA1, but the present disclosure is not limited thereto.

The polarizer 6 selectively transmits light to reduce the reflection of external light which is incident onto the display apparatus 1000. For example, the display apparatus may include various metal materials which are applied to the thin film transistor, the light emitting diode layer, and the wiring line. Thus, the external light incident onto the display apparatus may be reflected from the metal material so that the visibility of the display apparatus 1000 may be reduced due to the reflection of the external light. Therefore, the polarizer 6 is disposed on one surface of the display apparatus 1000 to suppress the reflection of the external light and increase an outdoor visibility of the display apparatus 1000.

However, the polarizer 6 may be omitted depending on the structure of the display apparatus 1000.

The polarizer 6 may be attached to the display panel 1 using the adhesive member 10.

The adhesive member 10 may be formed of a material having adhesiveness and for example, may be formed of an optically clear adhesive (OCA) or a pressure sensitive adhesive (PSA), but is not limited thereto.

A front member 7 may be disposed on the polarizer 6 and the cover layer 800. The front member 7 may be disposed in the first non-bending area NBA1 and the bending area BA. For example, the front member 7 may be disposed in the first non-bending area NBA1 and extends to a partial area of the bending area BA. The front member 7 may protect the display panel 1 and other components disposed below or above the front member from external shocks, moisture, and heat. The front member 7 may be formed of a material having an impact resistance and optical transmittance. For example, the front member 7 may be a substrate formed of glass or a film formed of a plastic material such as polymethylmethacrylate (PMMA), polyimide (PI), or polyethylene terephthalate (PET), but is not limited thereto. Further, the front member 7 may be referred to as various terms, such as a cover window, a window cover, or a cover glass, but the exemplary embodiments of the present disclosure are not limited thereto.

The front member 7 may be formed to be transparent to allow light emitted from the display panel 1 to transmit to the outside of the display apparatus and allow a user to see images provided by the display apparatus.

A blocking unit (not shown) may be disposed at an end of the front member 7. The blocking unit may be disposed to surround a part of the end of the display panel 1. The blocking unit may be formed to be opaque so that wiring lines, driving circuits, and various components formed below or above the front member 7 in the display apparatus are not visible to the user.

The blocking unit may include a light shielding material such as a pigment, a dye, and carbon black. For example, the blocking unit may be formed or coated with a black ink in the front member 7. Alternatively, the blocking unit 7 is formed at an edge of the rear surface of the front member 7 as a separate component to be attached to the front member 7.

The blocking unit may be disposed to overlap a part of at least one of the display panel 1, the first plate 3a, a support member 4, or a heat dissipation member 5. When the display panel 1 is bent, the blocking unit may be disposed so as to overlap a part of one or more of the second plate 3b or the flexible film 2.

A plate, a support member, and a heat dissipation member are provided on a rear surface of the display panel 1.

The plate may be disposed on the rear surface of the display panel 1. The display panel 1 may be supported and protected from the rear surface of the display panel 1. The plate may be formed of a material having a rigidity and a high thermal conductivity. For example, the plate may be formed of a metal material such as aluminum (Al), copper (Cu), zinc (Zn), silver (Ag), gold (Au), iron (Fe), stainless steel (SUS), or invar or a material, such as plastic, but the exemplary embodiments of the present disclosure are not limited thereto.

In the present disclosure, the plate may include a first plate 3a and a second plate 3b. The first plate 3a is disposed in the first non-bending area NBA1 and supports the display panel 1 having a flexible property so as to correspond to the active area AA of the display panel 1 to maintain a flat state of the display panel. The second plate 3b is disposed in the second non-bending area NBA2 and may support the display panel 1 and the flexible film 2 having a flexible property.

The first plate 3a and the second plate 3b may be attached to the display panel 1 using the adhesive member 10.

The adhesive member 10 may be formed of a material having adhesiveness and for example, may be formed of an optically clear adhesive (OCA) or a pressure sensitive adhesive (PSA), but is not limited thereto.

The support member 4 may be disposed on the rear surface of the first plate 3a in the first non-bending area NBA1.

The support member 4 may support one or more of a rear surface or a side surface of the display panel 1 and may have a plate shape.

The support member 4 may be formed of a material having a high rigidity and a high thermal conductivity. For example, the support member 4 may be formed of a metal material such as aluminum (Al), copper (Cu), zinc (Zn), silver (Ag), gold (Au), iron (Fe), stainless steel (SUS), or invar or a material, such as plastic, but the exemplary embodiments of the present disclosure are not limited thereto.

The support member 4 may be attached to the first plate 3a using the adhesive member 10.

The heat dissipation member 5 may be disposed on a rear surface of the support member 4.

The heat dissipation member 5 may dissipate heat transmitted from the display panel 1. The heat dissipation member 5 includes a material having an excellent thermal conductivity to disperse and dissipate heat transmitted from the display panel. For example, the heat dissipation member 5 may be formed of a metal material such as aluminum (Al), copper (Cu), zinc (Zn), silver (Ag), gold (Au), iron (Fe), stainless steel (SUS), invar, or graphite or a material, such as plastic, and may include at least one or more of one or more materials, an alloy material thereof, or bonding structures. However, the exemplary embodiments of the present disclosure are not limited thereto.

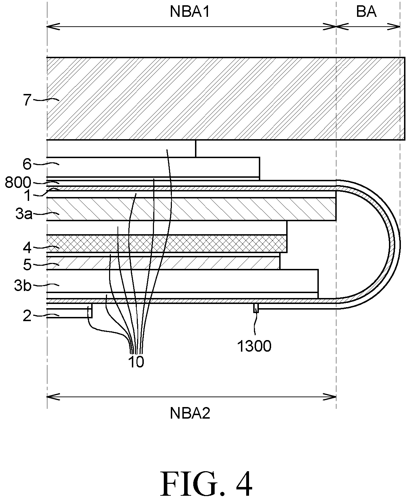

FIG. 4 is a cross-sectional view of a display apparatus according to an exemplary embodiment of the present disclosure.

FIG. 4 is substantially the same as FIG. 3 except for a configuration after bending so that a redundant description will be omitted.

In FIG. 4, the bending process may be performed after attaching the display panel and components disposed on a rear surface and a front surface of the display panel. The first non-bending area NBA1 and the second non-bending area NBA2 may be opposite to each other. Further, the second plate 3b and the heat dissipation member 5 may be attached using the adhesive member 10 by the bending process.

The cover layer 800 disposed in the bending area may be disposed on the display panel 1. For example, the cover layer 800 is formed on the display panel 1 in the bending area BA before the bending process to be bent together with the display panel 1 during the bending process to be disposed along the bending area.

The cover layer 800 disposed in the active area AA of the first non-bending area NBA1 may extend to the bending area BA and/or the second non-bending area NBA 2. For example, the cover layer 800 disposed in the active area AA of the first non-bending area NBA1 may extend to the bending area BA and extend to a partial area of the second non-bending area NBA 2, but the present disclosure is not limited thereto.

The cover layer 800 may cover the side surface of the display panel 1 disposed in the bending area BA. After placing a frame 13 which is formed to reinforce the side surface of the display panel after the bending process, the side surface of the display apparatus may be covered. Alternatively, the cover layer 800 may cover a part of the display panel 1 disposed in the non-bending area NBA.

The connection line 116 disposed in the bending area BA is vulnerable to the shocks from the outside to be shorted to cause the problem in that the display apparatus is not driven. In order to block the crack or short-circuit problem of the connection line 116, the cover layer 800 may be disposed.

The cover layer 800 protects the connection line 116 disposed in the bending area BA to suppress the short-circuit due to the shocks from the outside. Further, breakage or damage, for example, distortion or deformation of the display panel 1 may be suppressed.

The partition 1300 may be disposed in the non-bending area NBA and may be disposed to be vertically opposite to the active area AA. The partition 1300 may overlap at least a part of the active area AA.

FIG. 5 is a plan view illustrating a display driver of a display panel according to an exemplary embodiment of the present disclosure.

Referring to FIG. 5, the display panel 1 may include a substrate 110 having an active area AA and a non-active area NA.

The display panel 1 may include the substrate 110, a display driver DISP, an encapsulation unit 600, and a touch unit 700.

The display driver DISP including a thin film transistor and an light emitting diode layer may be disposed on the substrate 110. The encapsulation unit 600, the touch unit 700, the cover layer 800, and the partition 1300 may be disposed on the display driver DISP.

The substrate 110 may include an active area AA and a non-active area NA which surrounds the active area AA. The non-active area NA of the substrate 110 is adjacent to the active area AA and disposed at the outside from the active area AA.

The active area AA is an area in which pixels P are disposed to display images and may include a plurality of sub pixels SP1, SP2, and SP3. Each of the plurality of sub pixels SP1, SP2, and SP3 may include a light emitting diode layer for displaying images and a thin film transistor for driving the light emitting diode layer.

The pixel P disposed in the active area AA may further include a plurality of sub pixels SP1, SP2, and SP3 or may include a plurality of sub pixels SP1, SP2, SP3 and SP4. The plurality of sub pixels SP1, SP2, and SP3 or the plurality of sub pixels SP1, SP2, SP3 and SP4 is individual units which emit light and may emit red, green, blue, and/or white light and the exemplary embodiments of the present disclosure are not limited thereto.

One sub pixel SP may include a plurality of transistors T, a capacitor C, and a plurality of wiring lines. For example, one sub pixel SP may be configured with a structure 2T1C including two transistors and one capacitor, but is not limited thereto and may be configured with 3T1C, 4T1C, 5T1C, 6T1C, 7T1C, 3T2C, 4T2C, 5T2C, 6T2C, 7T2, and 8T2C, and may be implemented according to a structure and a type of thin film transistor.

Active layers of thin-film transistors TFTs may be formed of a semiconductor material, such as an oxide semiconductor, amorphous semiconductor, or polycrystalline semiconductor, but is not limited thereto.

The oxide semiconductor material may have an excellent effect of preventing a leakage current and relatively inexpensive manufacturing cost. The oxide semiconductor may be made of a metal oxide such as zinc (Zn), indium (In), gallium (Ga), tin (Sn), and titanium (Ti) or a combination of a metal such as zinc (Zn), indium (In), gallium (Ga), tin (Sn), or titanium (Ti) and its oxide. Specifically, the oxide semiconductor may include zinc oxide (ZnO), zinc-tin oxide (ZTO), zinc-indium oxide (ZIO), indium oxide (InO), titanium oxide (TiO), indium-gallium-zinc oxide (IG-ZO), indium-zinc-tin oxide (IZTO), indium zinc oxide (IZO), indium gallium tin oxide (IGTO), and indium gallium oxide (IGO), but is not limited thereto.

The polycrystalline semiconductor material has a fast movement speed of carriers such as electrons and holes and thus has high mobility, and has low energy power consumption and superior reliability. The polycrystalline semiconductor may be made of polycrystalline silicon (poly-Si), but is not limited thereto.

The amorphous semiconductor material may be made of amorphous silicon (a-Si), but is not limited thereto.

The non-active area NA may be an area where no image is displayed and various wiring lines and driving circuits for driving the plurality of sub pixels SP disposed in the active area AA are disposed. The non-active area NA does not display images so that a partial area of the non-active area NA of the substrate 110 may be bent to reduce the non-active area NA, for example, a bezel area.

Even though in FIG. 5, it is illustrated that the non-active area NA surrounds a quadrangular active area AA, a shape of the active area AA and a shape and placement of the non-active area NA adjacent to the active area AA are not limited to the example illustrated in FIG. 5. The active area AA and the non-active area NA may have shapes suitable for a design of an electronic device including the display apparatus 1000. In the case of a display apparatus which is wearable by a user may have a circular shape such as a watch and the exemplary embodiments of the present disclosure may also be applied to a free-form display apparatus which is applicable to a vehicle dash board. An exemplary shape of the active area AA may be a pentagon, a hexagon, a circle, or an oval, but is not limited thereto.

The display apparatus 1000 may further include various additional elements to generate various signals or drive a plurality of sub pixels SP1, SP2, and SP3 or a plurality of sub pixels SP1, SP2, SP3 and SP4 in an active area AA. For example, the driving circuit for controlling (or driving) the plurality of sub pixels SP1, SP2, and SP3 or the plurality of sub pixels SP1, SP2, SP3 and SP4 may include a gate driver 112, data signal lines, a multiplexer (MUX), an electrostatic discharge (ESD) circuit, a power line, an inverter circuit, a connection line 116, and the like. The power line may be a high potential voltage line and/or a low potential voltage line and the exemplary embodiments of the present disclosure are not limited thereto. The display apparatus 1000 may include additional elements other than a function for driving the plurality of sub pixels SP1, SP2, and SP3 or the plurality of sub pixels SP1, SP2, SP3 and SP4. For example, the display apparatus 1000 may include additional elements which provide a touch sensing function, a user authentication function (for example, fingerprint recognition), a multilevel pressure sensing function, or a tactile feedback function and the exemplary embodiments of the present disclosure are not limited thereto. The mentioned additional elements may be located in the non-active area NA or an external circuit connected to a connection interface and the exemplary embodiments of the present disclosure are not limited thereto.

The pad unit 114 may be disposed at one side of the non-active area NA. The pad unit 114 may be a metal pattern to which the external module, for example, a flexible film (flexible printed circuit board, FPCB) and a chip on film (COF) are bonded. Even though it is illustrated that the pad unit 114 is disposed at one side of the substrate 110, a shape and a placement of the pad unit 114 are not limited thereto.

The gate driver 112 which supplies a gate signal to the thin film transistor may be disposed in the non-active area NA at two sides of the active area AA, respectively, but the present disclosure is not limited thereto, the gate driver 112 may also be disposed in the non-active area NA at one side of the active area AA. The gate driver 112 includes various gate driving circuits and the gate driving circuits may be directly formed on the substrate 110. In this case, the gate driver 112 may be a gate-in-panel (GIP), but is not limited by the term.

The gate driver 112 may be disposed between the active area AA and the dam 117. The high potential voltage line VDD, the low potential voltage line VSS, the multiplexer (MUX), the electrostatic discharge (ESD) circuit unit, and the connection line 116 may be disposed between the active area AA and the pad unit 114 of the non-active area NA and the exemplary embodiments of the present disclosure are not limited thereto.

The high potential voltage line VDD, the low potential voltage line VSS, the multiplexer (MUX), and the connection line 116 may be disposed between the active area AA and the bending area BA. The high potential voltage line VDD, the low potential voltage line VSS, the multiplexer (MUX), and the connection line 116 may be disposed in the non-active area NA adjacent to the active area AA.

The connection line 116 may be disposed in a part of the non-active area NA. The connection line 116 may be disposed in the bending area BA of the display apparatus and the non-bending area adjacent to the bending area BA

The connection line 116 may be a configuration which transmits a signal (for example, a voltage) from the external module bonded to the pad unit 114 to the active area AA or a circuit unit such as the gate driver 112. For example, various signals and voltages, such as various gate signals, data signals, a high potential voltage, and a low potential voltage, may be transmitted through the connection line 116.

The connection line 116 may be classified into a power connection line and/or a signal connection line according to voltages and/or image signals to be transmitted.

The power connection line may transmit a voltage supplied from the external module to the active area AA. The power connection line may be connected to a low potential voltage line VSS, a high potential voltage line VDD, and a gate low voltage line and/or a gate high voltage line included in the gate driver, but is not limited thereto.

The signal connection line may transmit a signal supplied from the external module to the active area AA. The signal connection line may be connected to a scan line and/or a data line, but is not limited thereto.

The dam 117 may be disposed in the non-active area NA so as to surround all or a part of the active area AA. The dam 117 may be adjacent to the active area AA and may be disposed at the outside from the active area AA. The dam 117 may be disposed in the first non-bending area NBA1.

The dam 117 may be disposed along the periphery of the active area AA to control the flow of a layer including an organic material of the encapsulation unit disposed on the light emitting diode layer. The number of dams 117 may be one, two or plural and the exemplary embodiments of the present disclosure are not limited thereto.

A panel crack detector 118 may be further disposed in a part of the non-active area NA of the substrate 110.

The panel crack detector 118 may be disposed between an end point (or an end) of the substrate 110 and the dam 117 or may be disposed below the dam 117 and overlap at least a part of the dam 117.

The panel crack detector 118 is disposed at the outer periphery of the display apparatus to detect the defect, such as a crack which may be generated at the outer periphery of the display apparatus.

A hole H may be further included in the active area AA. A hole H is disposed between the plurality of sub pixels SP in the active area AA. The hole H may be an area in which an optical component, such as a camera or an optical sensor is disposed. The optical sensor may include a proximity sensor, an infrared sensor, and an ultraviolet sensor, but the exemplary embodiments of the present disclosure are not limited thereto. The hole H includes a hole H which passes through some configuration of the display apparatus 1000 to place the optical component so that a space for placing the optical component may be ensured.

The cover layer 800 may be disposed on a front surface of the substrate 110. For example, the cover layer 800 may cover all of the first non-bending area NBA1 and the bending area BA. Ends of three surfaces of the substrate 110 and an end of the cover layer 800 may coincide.

A partition 1300 which controls the cover layer 800 may be disposed at one side of the non-active area or a partition 1300 which controls the cover layer 800 may be disposed at one side of the second non-bending area NBA2. The partition 1300 may be disposed between the bending area BA and the pad unit 114. The partition 1300 may be disposed between the bending area BA and the flexible film 2.

The partition 1300 may be disposed along a periphery of the bending area BA to control the flow of the cover layer 800 which is configured with an organic material. The number of partitions 1300 may be one or plural and the exemplary embodiments of the present disclosure are not limited thereto.

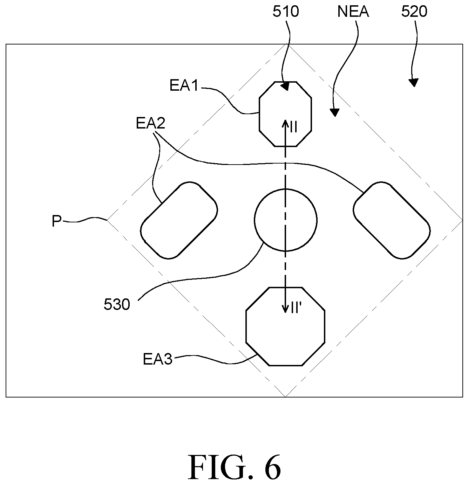

FIG. 6 is a view illustrating placement of an emitting unit and a non-emitting unit of a display apparatus according to the exemplary embodiment of the present disclosure.

The active area AA of the substrate 110 may include an emitting unit EA and a non-emitting unit NEA disposed between the emitting units.

The emitting unit EA is an area of the sub pixel SP in which light is emitted from the light emitting diode layer and each sub pixel may include the emitting unit. A plurality of emitting units EA may be disposed on the substrate and may be spaced part from each other. The non-emitting unit NEA may be disposed to surround the emitting unit.

The emitting unit EA may be an area of the emitting layer in which light is emitted to the outside and referring to FIG. 7, may be an area in which a bank 520 is not disposed.

The non-emitting unit NEA may be an area of the emitting layer in which light is not emitted to the outside and referring to FIG. 7, may be an area in which the bank 520 is disposed.

A plurality of emitting units which emits different color light may be located in the emitting unit EA. For example, the emitting units may include a first emitting unit EA1 which emits red light, a second emitting unit EA2 which emits green light, and a third emitting unit EA3 which emits blue light. The emitting units may further include a white emitting unit, etc., but are not limited thereto.

Each emitting unit EA is formed to have a specific shape to be disposed in a specific form as illustrated in FIG. 6, but the emitting unit EA of the display apparatus 1000 according to the present disclosure is not only disposed in a specific shape, but may be disposed in various shapes and forms. For example, an exemplary shape of each emitting unit EA may be a rectangle, a pentagon, a hexagon, an octagon, a circle, or an oval, but is not limited thereto. For example, the first emitting unit EA1 and the third emitting unit EA3 may have the same shape. The second emitting unit EA2 may have a shape different from the first emitting unit EA1. The second emitting unit EA2 may have a shape different from the third emitting unit EA3. For example, the second emitting unit EA2 may have a shape different from the first emitting unit EA1 and the third emitting unit EA3.

One pixel P may be formed by a plurality of sub pixels or emitting units which emit the same color light as illustrated in FIG. 6. For example, at least two or more second sub pixels SP2 or second emitting units EA2 may be disposed in one pixel P. At least two or more second emitting units EA2 which emit green light may be disposed in one pixel P and the exemplary embodiments of the present disclosure are not limited thereto.

A size of the third emitting unit EA3 may be larger than that of the other emitting units. For example, the size the third emitting unit EA3 may be larger than that of the first emitting unit EA1. The size of the third emitting unit EA3 which emits blue light may be larger than that of the first emitting unit EA1 which emits red light. For example, the size of the third emitting unit EA3 may be larger than that of the second emitting unit EA2. The size of the third emitting unit EA3 which emits blue light may be larger than that of the second emitting unit EA2 which emits green light. The third emitting unit EA3 may be disposed over the other emitting unit. For example, the third emitting unit EA3 may overlap at least a part of the first emitting unit EA1 and the second emitting unit EA2.

A spacer 530 may be disposed to have a predetermined distance (or an interval) from the plurality of sub pixels SP. For example, the spacer 530 is spaced apart from the plurality of sub pixels SP with a predetermined distance and may be disposed to be surroundd by the plurality of sub pixels SP. For example, as illustrated in FIG. 6, four sub pixels may surround one spacer, but are not limited thereto and five, six, seven, and eight sub pixels may be configured and implemented according to a structure and a type of the display apparatus.

The spacer 530 may be disposed substantially in the center of a plurality of sub pixels emitting at least one same color. For example, the spacer 530 may be disposed in the center of the second emitting unit EA2.

The spacer 530 may minimize the display apparatus 1000 from being broken due to the external impact by buffering an empty space between the substrate 110 on which the light emitting diode layer 500 is formed and the upper substrate.

Further, the spacer 530 may protect the light emitting diode layer 500. For example, when the light emitting diode layer 500 is formed, a fine metal mask (FMM) may be used. The fine metal mask may sag due to its weight during the process. Therefore, the spacer 530 is disposed so that the fine metal mask (FMM) is in contact with the spacer 530 so that the deformation or damage of the bank 520 caused by the direct contact between the fine metal mask and the bank 520 may be suppressed.

Hereinafter, a cross-sectional structure of the present disclosure will be described in detail with reference to FIGS. 7 and 8.

FIG. 7 is a cross-sectional view taken along the line II-II' of FIG. 6 according to an exemplary embodiment of the present disclosure.

FIG. 7 is a view illustrating a part of a cross-sectional structure of one sub pixel SP disposed in an active area illustrated in FIG. 6. The sub pixel SP may include an light emitting diode layer 500 for displaying images and a plurality of first thin film transistors 200 and a second thin film transistor 300 for driving the light emitting diode layer 500.

The substrate 110 may support various components of the display apparatus. The substrate 110 may be formed of a glass or a plastic material having flexibility.

For example, the substrate 110 may be formed of at least one of polyimide (PI), polymethylmethacrylate (PMMA), polyethylene terephthlate (PET), polyethersulfone, and polycarbonate (PC), but is not limited thereto.

When the substrate 110 is formed of polyimide, the substrate may be configured by two polyimide layers. An inorganic film may be further disposed between two polyimide layers.

The substrate 110 may include a first substrate, a second l substrate, and a third substrate. The second substrate is disposed on the first substrate, and the third 1 substrate is disposed on the second substrate.

The first substrate and the third substrate may be substrates configured to support the components formed on the substrate. The first substrate and the third substrate may be flexible substrates made of a plastic material. In this case, the flexibility may be interpreted in the same way as bendable, unbreakable, rollable, and foldable properties and the like.

For example, the first substrate and the third substrate may include plastic. In this case, the first substrate and the third substrate may be referred to as plastic films or plastic substrates. For example, the first substrate and the third substrate may include at least one selected from a group consisting of polyester-based polymer, silicon-based polymer, acrylic-based polymer, polyolefin-based polymer, and a polymer thereof. For example, the first substrate and the third substrate may be polyimide substrates made of polyimide (PI). However, the present disclosure is not limited thereto.

The second substrate may include an inorganic insulating material. The second substrate may be an inorganic film formed between the first substrate and the third substrate. For example, the second substrate may be configured as a single layer or multilayer made of silicon nitride (SiNx) or silicon oxide (SiOx). For example, the second substrate may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the present disclosure is not limited thereto.

An element and a functional layer formed on the substrate 110, for example, a switching thin film transistor, a driving thin film transistor connected to the switching thin film transistor, an organic light emitting diode connected to the driving thin film transistor, a protection layer, and the like may be included, but are not limited thereto.

A first insulating layer 120 may be disposed on the entire substrate 110. For example, the first insulating layer 120 may be disposed on the entire surface of the substrate 110.

The first insulating layer 120 is formed on the substrate 110 to block a material in the substrate 110 from moving to the thin film transistor or the semiconductor layer during a deposition process.

The first insulating layer 120 may be formed of an insulating inorganic material such as silicon nitride (SiNx) or silicon oxide (SiOx) or other insulating organic material, but is not limited thereto.

The first insulating layer 120 may be formed by a single layer of silicon nitride (SiNx) or silicon oxide (SiOx) or a multilayer thereof, but the exemplary embodiments of the present disclosure are not limited thereto. When the first insulating layer 120 is formed by multiple layers, silicon oxide (SiOx) and silicon nitride (SiNx) may be alternately formed, but the exemplary embodiments of the present disclosure are not limited thereto. For example, the first insulating layer 120 may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (Si-Ox) films, one or more silicon nitride (SiNx) films, and one or more amorphous silicon (a-Si), but the present disclosure is not limited thereto.

The first insulating layer 120 may be a buffer layer or a first buffer layer, but the exemplary embodiments of the present disclosure are not limited thereto.

The first insulating layer 120 may be omitted according to a type or a material of the substrate 110 and a structure and a type of the thin film transistor.

A first thin film transistor 200 and a second thin film transistor 300 may be disposed on the first insulating layer 120. The first thin film transistor 200 may be a switching thin film transistor and the second thin film transistor 300 may be a driving thin film transistor and the exemplary embodiments of the present disclosure are not limited thereto.

The first thin film transistor 200 may include a first semiconductor layer 210, a first gate electrode 230, a first source electrode 250, and a first drain electrode 270. The second thin film transistor 300 may include a second semiconductor layer 310, a second gate electrode 330, a second source electrode 350, and a second drain electrode 370.

For the convenience of description, only two thin film transistors, among various thin film transistors, are illustrated, but other thin film transistors may also be included in the display apparatus 1000. Further, for the convenience of description, the thin film transistor is illustrated as a top gate structure in which a gate electrode which configures the thin film transistor is located above the semiconductor layer, but it is not limited to this structure. Therefore, the thin film transistor is also implemented as another structure, such as a bottom gate structure in which the gate electrode is disposed below the semiconductor layer or a double gate structure in which gate electrodes are disposed above and below the semiconductor layer.

The first semiconductor layer 210 of the first thin film transistor 200 and the second semiconductor layer 310 of the second thin film transistor 300 may be disposed on the first insulating layer 120.

The first semiconductor layer 210 and the second semiconductor layer 310 may be formed of polycrystalline semiconductors. For example, the polycrystalline semiconductor may be formed of a low temperature poly silicon (LTPS) having a high mobility, but is not limited thereto. When the first semiconductor layer 210 and the second semiconductor layer 310 are formed of polycrystalline semiconductor, energy power consumption is low and reliability is excellent.

Further, the first semiconductor layer 210 and the second semiconductor layer 310 may be formed of oxide semiconductors. For example, the first semiconductor layer 210 and the second semiconductor layer 310 may be formed of any one of indium gallium zinc oxide (IGZO), indium zinc oxide (IZO), indium gallium tin oxide (IGTO), and indium gallium oxide (IGO), but is not limited thereto. When the first semiconductor layer 210 and the second semiconductor layer 310 are formed of an oxide semiconductor, it has an excellent effect to block the leakage current so that the luminance variation of the sub pixel during the low speed driving may be minimized.

When the first semiconductor layer 210 and the second semiconductor layer 310 are formed of a polycrystalline semiconductor or an oxide semiconductor, a conductive area may be provided in a partial area of the first semiconductor layer 210 and the second semiconductor layer 310.

The first semiconductor layer 210 and the second semiconductor layer 310 may be formed of amorphous silicon (a-Si) or various organic semiconductor materials such as pentacene, but are not limited thereto.

A second insulating layer 130 may be disposed in the entire area of the substrate 110 on the first semiconductor layer 210 and the second semiconductor layer 310.

The second insulating layer 130 is disposed between the first semiconductor layer 210 and the first gate electrode 230 to insulate the first semiconductor layer 210 and the first gate electrode 230 from each other. The second insulating layer 130 is disposed between the second semiconductor layer 310 and the second gate electrode 330 to insulate the second semiconductor layer 310 and the second gate electrode 330 from each other.

The second insulating layer 130 may be formed of an insulating inorganic material such as silicon nitride (SiNx) or silicon oxide (SiOx) or other insulating organic material, but is not limited thereto. For example, the second insulating layer 130 may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the present disclosure is not limited thereto.

The second insulating layer 130 may include a hole to electrically connect each of the first source electrode 250 and the first drain electrode 270 to the first semiconductor layer 210. The second insulating layer 130 may include a hole to electrically connect each of the second source electrode 350 and the second drain electrode 370 to the second semiconductor layer 310.

The first gate electrode 230 of the first thin film transistor 200 and the second gate electrode 330 of the second thin film transistor 300 may be disposed on the second insulating layer 130. The first gate electrode 230 may be disposed so as to overlap the first semiconductor layer 210. The second gate electrode 330 may be disposed so as to overlap the second semiconductor layer 310.

A storage capacitor 400 may be disposed on the second gate insulating layer 130. The storage capacitor 400 may include a first capacitor electrode 410 and a second capacitor electrode 420. The storage capacitor 400 stores a data voltage applied through a data line for a predetermined period to supply the data voltage to the first electrode 510.

The first capacitor electrode 410 of the storage capacitor 400 may be disposed on the second insulating layer 130.

The first gate electrode 230, the second gate electrode 330, and the first capacitor electrode 410 may be disposed on the same layer. For example, the first gate electrode 230, the second gate electrode 330, and the first capacitor electrode 410 may be disposed on the second insulating layer 130.

The first gate electrode 230, the second gate electrode 330, and the first capacitor electrode 410 may be formed by the same process.

The first gate electrode 230, the second gate electrode 330, and the first capacitor electrode 410 may be formed as a single layer or multiple layers formed of any one of molybdenum (Mo), copper (Cu), titanium (Ti), aluminum (Al), chrome (Cr), gold (Au), nickel (Ni), neodymium (Nd), tungsten (W), and transparent conductive oxide (TCO), or an alloy thereof, but are not limited thereto.

A third insulating layer 140 may be disposed on the entire area of the substrate 110 on the first gate electrode 230, the second gate electrode 330, and the first capacitor electrode 410.

The third insulating layer 140 is disposed between the first gate electrode 230, and the first source electrode 250 and the first drain electrode 270 to insulate the first gate electrode 230 from the first source electrode 250 and the first drain electrode 270. The third insulating layer 140 is disposed between the second gate electrode 330, and the second source electrode 350 and the second drain electrode 370 to insulate the second gate electrode 330 from the second source electrode 350 and the second drain electrode 370.

The third insulating layer 140 may include a hole to electrically connect each of the first source electrode 250 and the first drain electrode 270 to the first semiconductor layer 210. The third insulating layer 140 may include a hole to electrically connect each of the second source electrode 350 and the second drain electrode 370 to the second semiconductor layer 310.

The third insulating layer 140 may be formed of an insulating inorganic material such as silicon nitride (SiNx) or silicon oxide (SiOx) or other insulating organic material, but is not limited thereto. For example, the third insulating layer 140 may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the present disclosure is not limited thereto.

The second capacitor electrode 420 of the storage capacitor 400 may be disposed on the third insulating layer 140. The second capacitor electrode 420 may be disposed so as to overlap the first capacitor electrode 410.

The second capacitor electrode 420 may be formed as a single layer or multiple layers formed of any one of molybdenum (Mo), copper (Cu), titanium (Ti), aluminum (Al), chrome (Cr), gold (Au), nickel (Ni), neodymium (Nd), tungsten (W), and transparent conductive oxide (TCO), or an alloy thereof, but is not limited thereto.

A fourth insulating layer 150 may be disposed in the entire area of the substrate 110 on the second capacitor electrode 420.

The fourth insulating layer 150 is disposed between the first gate electrode 230, and the first source electrode 250 and the first drain electrode 270 to insulate the first gate electrode 230 from the first source electrode 250 and the first drain electrode 270. The fourth insulating layer 150 is disposed between the second gate electrode 330, and the second source electrode 350 and the second drain electrode 370 to insulate the second gate electrode 330 from the second source electrode 350 and the second drain electrode 370.

The fourth insulating layer 150 may include a hole to electrically connect each of the first source electrode 250 and the first drain electrode 270 to the first semiconductor layer 210. The fourth insulating layer 150 may include a hole to electrically connect each of the second source electrode 350 and the second drain electrode 370 to the second semiconductor layer 310.

The fourth insulating layer 150 may be formed of an insulating inorganic material such as silicon nitride (SiNx) or silicon oxide (SiOx) or other insulating organic material, but is not limited thereto. For example, the fourth insulating layer 150 may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the present disclosure is not limited thereto.

The first source electrode 250 and the first drain electrode 270 may be disposed above the fourth insulating layer 150. The second source electrode 350 and the second drain electrode 370 may be disposed above the fourth insulating layer 150.

Each of the first source electrode 250 and the first drain electrode 270 may be electrically connected to the first semiconductor layer 210 through the holes of the second insulating layer 130, the third insulating layer 140, and the fourth insulating layer 150. Each of the second source electrode 350 and the second drain electrode 370 may be electrically connected to the second semiconductor layer 310 through the holes of the second insulating layer 130, the third insulating layer 140, and the fourth insulating layer 150.

The first source electrode 250, the first drain electrode 270, the second source electrode 350, and the second drain electrode 370 may be formed as a single layer or multiple layers formed of any one of molybdenum (Mo), copper (Cu), titanium (Ti), aluminum (Al), chrome (Cr), gold (Au), nickel (Ni), neodymium (Nd), tungsten (W), and transparent conductive oxide (TCO), or an alloy thereof, but are not limited thereto. For example, the first source electrode 250, the first drain electrode 270, the second source electrode 350, and the second drain electrode 370 may be configured with a triple-layered structure of titanium (Ti)/aluminum (Al)/titanium (Ti) formed of conductive metal materials, but are not limited thereto.

A fifth insulating layer 160 may be disposed on the entire area of the substrate 110 on the first source electrode 250, the first drain electrode 270, the second source electrode 350, and the second drain electrode 370.

The fifth insulating layer 160 may protect the first thin film transistor 200 and the second thin film transistor 300. The fifth insulating layer 160 may be formed of an insulating inorganic material such as silicon nitride (SiNx) or silicon oxide (SiOx) or other insulating organic material, but is not limited thereto. For example, the fifth insulating layer 160 may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the present disclosure is not limited thereto.

The fifth insulating layer 160 may include a hole to electrically connect the second thin film transistor 300 to the connection electrode 180 or the first electrode 510. The fifth insulating layer 160 may be omitted according to a structure and a type of the thin film transistor.

The protection layer 170 may be disposed on the fifth insulating layer 160. For example, the protection layer 170 may be an insulating layer or a planarization layer, but the exemplary embodiments of the present disclosure are not limited thereto. The protection layer 170 may protect the thin film transistor disposed below the protection layer 170 and relieve or planarize a step caused by various patterns of the components of the thin film transistor. For example, the protection layer 170 may insulate components disposed above and below the protection layer 170. For example, the protection layer 170 may be disposed as a single layer, but may be disposed by two or more layers in consideration of the placement of the electrode.

As the display apparatus 1000 is developed to a higher resolution, various signal lines increase, so that it is difficult to place all wiring lines on one layer while ensuring the minimum interval. Therefore, additional layers may be configured. There is a margin in the placement of the wiring line by providing the additional layer, which makes it easier to design the electric wire/electrode placement. Further, when a dielectric material is used for the planarization layer configured by a plurality of layers, the protection layer 170 may be utilized to form a capacitance between metal layers.

When two protection layers 170 are provided, the protection layers may include a first protection layer 171 and a second protection layer 172. For example, the first protection layer 171 may be a sixth insulating layer, but the exemplary embodiments of the present disclosure are not limited thereto. For example, the second protection layer 172 may be a seventh insulating layer, but the exemplary embodiments of the present disclosure are not limited thereto. For example, a hole is formed in the first protection layer 171 and a connection electrode 180 may be disposed in the hole. The second protection layer 172 having a hole may be disposed on the first protection layer 171 and the connection electrode 180. The first electrode 510 may be disposed in the hole of the second protection layer 172. Therefore, the first thin film transistor 200 and the first electrode 510 may be electrically connected through the connection electrode 180.

One end (or a part or one side) of the connection electrode 180 may be connected to the second thin film transistor 300 and the other end (or the other part or the other side) of the connection electrode 180 may be connected to the first electrode 510.

The connection electrode 180 may be further disposed on the first protection layer 171.

The connection electrode 180 may be formed as a single layer or multiple layers formed of any one of molybdenum (Mo), copper (Cu), titanium (Ti), aluminum (Al), chrome (Cr), gold (Au), nickel (Ni), neodymium (Nd), tungsten (W), and transparent conductive oxide (TCO), or an alloy thereof, but is not limited thereto. For example, the connection electrode 180 may be formed with a triple-layered structure of titanium (Ti)/aluminum (Al)/titanium (Ti) formed of a conductive metal material.

The connection electrode 180 may be a first connection electrode, but the exemplary embodiments of the present disclosure are not limited thereto. The connection electrode 180 may be omitted depending on the structure or the type of the display apparatus 1000.

The second protection layer 172 may be disposed on the first protection layer 171 and the connection electrode 180.

The first protection layer 171 and the second protection layer 172 may be formed of at least one or more materials of organic insulating materials, such as benzocyclobutene (BCB), acrylic resin, epoxy resin, phenolic resin, polyamide resin, or polyimide resin, but are not limited thereto.

The protection layer 170 of the display apparatus 1000 may be disposed as three layers in consideration of the placement of the electrode, but the exemplary embodiments of the present disclosure are not limited thereto. Accordingly, the connection electrode may be further disposed.

The light emitting diode layer 500 may be disposed on the protection layer 170 or the second protection layer 172. The light emitting diode layer 500 may include a first electrode 510, an emitting layer 540, and a second electrode 550.

The first electrode 510 may be disposed on the protection layer 170. The first electrode 510 supplies holes to the emitting layer 540 and may be formed of a conductive material having a high work function. The first electrode may be an anode electrode and the exemplary embodiments of the present disclosure are not limited thereto.

When the display apparatus 1000 is a top emission type, the first electrode 510 may be disposed using an opaque conductive material as a reflective electrode which reflects light. The first electrode 510 may be formed by at least one or more of silver (Ag), aluminum (Al), gold (Au), molybdenum (Mo), tungsten (W), chrome (Cr), or an alloy thereof, but the exemplary embodiments of the present disclosure are not limited thereto. For example, the first electrode 510 may be formed with a triple-layered structure of silver (Ag)/palladium (Pd)/copper (Cu), but is not limited thereto. Alternatively, the first electrode 510 may further include a transparent conductive material layer having a high work function, such as indium tin oxide (ITO)or indium zinc oxide (IZO).

When the display apparatus 1000 is a bottom emission type, the first electrode 510 may be disposed using a transparent conductive material through which light passes. For example, the first electrode 510 may be formed of at least one or more of indium tin oxide (ITO) and indium zinc oxide (IZO), but the exemplary embodiments of the present disclosure are not limited thereto.

The bank 520 may be disposed on the first electrode 510 and the protection layer 170.

The bank 520 may divide the plurality of sub pixels SP, minimize the glaring phenomenon, and suppress color mixture at various viewing angles. The bank 520 may define (or divide) an emitting unit in which light is emitted and a non-emitting unit in which light is not emitted and may be disposed in the non-emitting unit. The bank 520 may have a bank hole which exposes the emitting unit and the first electrode 510.

The bank 520 may be formed of at least one or more materials among inorganic insulating materials, such as silicon nitride (SiNx) or silicon oxide (SiOx), organic insulating materials, such as benzocyclobutene (BCB), acrylic resin, epoxy resin, phenolic resin, polyamide resin, or polyimide resin, or photosensitizers including a black pigment, but is not limited thereto.

The bank 520 may be formed to be black or colored. For example, when the bank 520 includes a black material, external light, internal reflected light, and/or scattered light scattered from the side surface of the first electrode 510 may be suppressed from entering the thin film transistor, and the deterioration of luminance of the display apparatus may be improved. The bank 520 may be disposed so as to cover an end (or a partial area) of the first electrode 510.

At least one spacer 530 may be disposed on the bank 520.

The spacer 530 may suppress the damage of the emitting layer 540 during the process of the emitting layer 540 and minimize the breakage of the display apparatus 1000 caused by the external shocks.

The spacer 530 may be formed of the same material as the bank 520 and may be formed simultaneously with the bank 520, or formed by a separate process. For example, the spacer 530 may be formed to be transparent, or black or colored. Alternatively, the spacer 530 may include a transparent material, a black material, or a colored material.

A thickness of the spacer 530 may be equal to or larger than a thickness of the bank 520 and a thickness of the spacer 530 may be 1 µm to 2 µm, but the exemplary embodiments of the present disclosure are not limited thereto.

The emitting layer 540 may be disposed on the first electrode 510 and the bank 520. The emitting layer 540 may include an emitting layer EML for emitting light with a specific color in each of the plurality of sub pixels SP. The emitting layer may be a layer in which light is emitted. For example, holes generated in the first electrode 510 and electrons generated in the second electrode 550 may be injected into the emitting layer. Holes and electrons injected into the emitting layer are coupled to generate exciton. When the generated exciton falls from an excited state to a ground state, light may be generated.

For example, the emitting layer may include one of a red emitting layer which emits red light, a green emitting layer which emits green light, a blue emitting layer which emits blue light, and a white emitting layer. When the emitting layer 540 includes the white emitting layer, a color filter for converting white light from the white emitting layer into another color light may be disposed above the emitting layer 540. Further, the emitting layer 540 may further include a hole injection layer (HIL), a hole transport layer (HTL), an electron blocking layer (EBL), a hole blocking layer (HBL), an electron transport layer (ETL), and an electron injection layer (EIL), a hole blocking layer (HBL), and an electron blocking layer (EBL) disposed above or below the emitting layer. However, it is not limited thereto.

The emitting layer 540 may be disposed in each of the plurality of sub pixels SP and the hole injection layer (HIL), the hole transport layer (HTL), the electron blocking layer (EBL), the hole blocking layer (HBL), the electron transport layer (ETL), and the electron injection layer (EIL) may be disposed in the entire active area AA.

The emitting layer 540 of the display apparatus according to the present disclosure may be an emitting unit. At least one or more emitting units may be disposed. For example, the plurality of emitting units is laminated between the first electrode 510 and the second electrode 550 to configure a stack structure. In this case, a charge generating layer may be further disposed between the plurality of emitting units. A plurality of emitting units may be disposed in each sub pixel SP.

The second electrode 550 may be disposed on the emitting layer 540. The second electrode 550 supplies electrons to the emitting layer 540 and may be formed of a conductive material having a low work function. The second electrode 550 may be a cathode electrode, but the exemplary embodiments of the present disclosure are not limited thereto.

When the display apparatus 1000 is a top emission type, the second electrode 550 may be disposed using a transparent conductive material through which light passes. For example, the second electrode may be formed of at least one of indium tin oxide (ITO) and indium zinc oxide (IZO), but is not limited thereto. Further, the second electrode 550 may be disposed using a translucent conductive material through which light passes. For example, the second electrode may be formed of at least one of alloys such as LiF/Al, CsF/Al, Mg:Ag, Ca/Ag, Ca:Ag, LiF/Mg:Ag, LiF/Ca/Ag, and LiF/Ca:Ag, but is not limited thereto.

When the display apparatus 1000 is a bottom emission type, the second electrode 550 may be disposed using an opaque conductive material as a reflective electrode which reflects light. For example, the second electrode 550 may be formed of at least one or more of silver (Ag), aluminum (Al), gold (Au), molybdenum (Mo), tungsten (W), chrome (Cr), or an alloy thereof.

An encapsulation unit 600 may be disposed on the second electrode 550. The encapsulation unit 600 may protect the emitting layer 540 from moisture, oxygen, or foreign materials of the outside. For example, the permeation of the oxygen and moisture from the outside may be suppressed to avoid oxidation of an emitting material and an electrode material.

The encapsulation unit 600 may include a first encapsulation layer 610, a second encapsulation layer 620, and a third encapsulation layer 630 which block the permeation of moisture or oxygen. The first encapsulation layer 610, the second encapsulation layer 620, and the third encapsulation layer 630 may be alternately laminated, but the exemplary embodiments of the present disclosure are not limited thereto.

The encapsulation unit 600 may be formed of a transparent material to transmit light emitted from the emitting layer.

The first encapsulation layer 610 and the third encapsulation layer 630 may be formed of at least one inorganic material among silicon nitride (SiNx), silicon oxide (SiOx), and silicon aluminum (AlyOz), but is not limited thereto. The first encapsulation layer 610 and the third encapsulation layer 630 may be formed using a vacuum film forming method such as chemical vapor deposition (CVD) or atomic layer deposition (ALD), but are not limited thereto.

The first encapsulation layer 610 and the third encapsulation layer 630 may be formed by at least two or more layers. For example, the first encapsulation layer 610 may be formed with a triple-layered structure of silicon oxide (SiOx)/silicon nitride (SiNx)/silicon oxide (SiOx), but is not limited thereto. Further, the first encapsulation layer 610 may be formed with a quadruple-layered structure of silicon oxide (SiOx)/silicon nitride (SiNx)/silicon oxide (SiOx)/silicon oxide (SiOx), but is not limited thereto.

The second encapsulation layer 620 may cover foreign materials or particles which may be generated during a manufacturing process. Further, the second encapsulation layer 620 may planarize a surface of the first encapsulation layer 610. For example, the second encapsulation layer 620 may be a particle cover layer, but is not limited to the term.

The second encapsulation layer 620 may be an organic material, for example, a polymer such as silicon oxy carbon (SiOCz), epoxy, polyimide, polyethylene, or acrylate, but is not limited thereto.

The second encapsulation layer 620 may be formed of a thermosetting material or a photo curable material which is cured by heat or light.

The second encapsulation layer 620 may be formed by various methods such as inkjet coating or slit coating. For example, the second encapsulation layer 620 may be formed on the first encapsulation layer 610 by spraying or dropping a liquid organic material on the substrate 110 on which the first encapsulation layer 610 is formed, in the active area AA using an inkjet device or a nozzle coating device. A fluid organic material may be formed in an applying area while the spraying nozzle moves on the applying area (or a nozzle is fixed and a subject moves).

A material which configures the second encapsulation layer 620 has a low viscosity characteristic so that it may be in a liquid state having a high density until the material is cured. In order to solve the problem in that the second encapsulation layer 620 is spread (or flows) to the non-active area NA, a dam 117 may be disposed in the non-active area NA.

Meanwhile, the encapsulation unit 600 is not limited to three layers, for example, n layers alternately stacked between inorganic encapsulation layer and organic encapsulation layer (where n is an integer greater than 3) may be included.

The dam 117 will be described in detail with reference to FIG. 8.

A touch unit 700 may be disposed on the encapsulation unit 600.

The touch unit 700 may include a first touch electrode 740_R, a first touch connection electrode 720, a second touch electrode, and a second touch connection electrode 740_C.

A part of the first touch electrode 740_R, the first touch connection electrode 720, the second touch electrode, and the second touch connection electrode 740_C may be disposed so as to overlap the bank 520.

The first touch electrode 740_R, the second touch electrode, the first touch connection electrode 720, and the second touch connection electrode 740_C may be formed with a mesh pattern in which metal lines having a small line width intersect each other. The mesh pattern may have a rhombic shape. Further, the shape of the mesh pattern may be a rectangle, a pentagon, a hexagon, a circle, or an oval, but is not limited thereto.

The first touch electrode 740_R, the second touch electrode, the first touch connection electrode 720, and the second touch connection electrode 740_C may be disposed using an opaque conductive material having a low resistance. For example, the first touch electrode 740_R, the second touch electrode, the first touch connection electrode 720, and the second touch connection electrode 740_C may be formed as a single layer or multiple layers formed of any one of molybdenum (Mo), copper (Cu), titanium (Ti), aluminum (Al), chrome (Cr), gold (Au), nickel (Ni), neodymium (Nd), tungsten (W), and transparent conductive oxide (TCO), or an alloy thereof, but are not limited thereto. For example, the first touch electrode 740_R, the second touch electrode, the first touch connection electrode 720, and the second touch connection electrode 740_C may be configured with a triple-layered structure of titanium (Ti)/aluminum (Al)/titanium (Ti) formed of conductive metal materials, but are not limited thereto.

The first touch electrode 740_R, the second touch electrode, the first touch connection electrode 720, and the second touch connection electrode 740_C may be formed of the same material as the first source electrode 250, the first drain electrode 270, the second source electrode 350, and the second drain electrode 370. However, the exemplary embodiments of the present disclosure are not limited thereto.

A buffer layer 710 may be disposed on the encapsulation unit 600. The buffer layer 710 may block a liquid chemical (developer or etchant) used during the process of manufacturing the touch unit 700 or moisture from the outside from being permeated into the light emitting diode layer 500 including an organic material. Further, the short-circuit of a plurality of touch sensor metals disposed above the buffer layer 710 due to the external shock may be suppressed and an interference signal which may be generated while driving the touch unit 700 may be blocked. For example, the buffer layer 710 may be a touch buffer layer, a second buffer layer, or an eighth insulating layer, but the exemplary embodiments of the present disclosure are not limited thereto.

The buffer layer 710 may be formed of at least one or more materials among inorganic insulating materials, such as silicon nitride (SiNx) or silicon oxide (SiOx) and organic insulating materials, such as benzocyclobutene (BCB), acrylic resin, epoxy resin, phenolic resin, polyamide resin, or polyimide resin, but is not limited thereto.

The first touch connection electrode 720 may be disposed on the buffer layer 710.

For example, the first touch connection electrode 720 may be disposed between the first touch electrodes 740_R adjacent in the first direction (or the X-axis direction). The first touch connection electrode 720 may electrically connect the plurality of first touch electrodes 740_R which is spaced apart in the first direction (or the X-axis direction) to be adjacent, but is not limited thereto.

The first touch connection electrode 720 may be disposed so as to overlap the second touch connection electrode 740_C which connects the second touch electrodes adjacent in the second direction (or the Y-axis direction). The first touch connection electrode 720 and the second touch connection electrode 740_C are formed on different layers to be electrically insulated. For example, the first touch connection electrode 720 may be a connection electrode or a second connection electrode, but the exemplary embodiments of the present disclosure are not limited thereto. For example, the second touch connection electrode 740_C may be a third connection electrode, but the exemplary embodiments of the present disclosure are not limited thereto.

An insulating layer 730 may be disposed on the buffer layer 710 and the first touch connection electrode 720. For example, the insulating layer 730 may be a touch insulating layer or a ninth insulating layer, but the exemplary embodiments of the present disclosure are not limited thereto.

The insulating layer 730 may include a hole to electrically connect the first touch electrode 740_R and the first touch connection electrode 720. For example, the insulating layer 730 may electrically insulate the second touch electrode and the second touch connection electrode 740_C. For example, the insulating layer 730 may be an organic material, for example, a polymer such as silicon oxy carbon (SiOCz), epoxy, polyimide, polyethylene, or acrylate, but is not limited thereto. The insulating layer 730 may be formed of a thermosetting material or a photo curable material which is hardened by heat or light.

When the insulating layer 730 is configured with an inorganic material, the insulating layer 730 is disposed along sharp step and curve of various components disposed below the insulating layer 730. Accordingly, the sharp step and curve are not covered so that there may be a problem in that a part of internal components of the display apparatus may be visible to the outside. It is recognized as a defect such as a spot by the user so that an aesthetic sensibility of the users may be degraded. Further, an insulating layer configured with an inorganic material is less effective to block moisture and oxygen permeating from the outside of the display apparatus, than an insulating layer configured with an organic material. Further, an insulating layer configured with an inorganic material cannot cover foreign materials or particles which may be generated during a manufacturing process. When the insulating layer 730 is configured with the organic material, during the manufacturing process of the display apparatus including a bending area, the problems of the crack and the short-circuit of the wiring line caused by the mechanical stress in the bending area during the bending process of the plate or after the bending process may be avoided.

The first touch electrode 740_R, the second touch electrode, and the second touch connection electrode 740_C may be disposed on the insulating layer 730.

The first touch electrode 740_R and the second touch electrode may be disposed to be spaced apart from each other with a predetermined interval. At least one first touch electrode 740_R adjacent in the first direction (or the X-axis direction) may be formed to be spaced apart from each other. At least one or more first touch electrodes 740_R adjacent to each other in the first direction (or the X-axis direction) may be connected to the first touch connection electrode 720 disposed between the plurality of first touch electrodes 740_R. For example, the plurality of adjacent first touch electrodes 740_R may be connected to the first touch connection electrode 720 by means of the hole of the insulating layer 730.

The second touch electrode adjacent in the second direction (or the Y-axis direction) may be connected by the second touch connection electrode 740_C. The second touch electrode and the second touch connection electrode 740_C may be formed on the same layer. For example, the second touch connection electrode 740_C may be disposed between the plurality of second touch electrodes on the same layer as the second touch electrode. The second touch connection electrode 740_C extends from the second touch electrode.

The first touch electrode 740_R, the second touch electrode, and the second touch connection electrode 740_C may be formed by the same process.

A third protection layer 750 may be disposed on the first touch electrode 740_R, the second touch electrode, and the second touch connection electrode 740_C. For example, the third protection layer 750 may be a planarization layer, a touch planarization layer, a tenth insulating layer, or a third protection layer, but the exemplary embodiments of the present disclosure are not limited thereto.

The touch driving circuit may receive a touch sensing signal from the first touch electrode 740_R. Further, the touch driving circuit may transmit a touch driving signal from the second touch electrode. The touch driving circuit may sense the user's touch using mutual capacitance between the plurality of first touch electrodes 740_R and the second touch electrode. For example, when the touch operation is performed on the display apparatus 1000, a capacitance between the first touch electrode 740_R and the second touch electrode may be changed. The touch driving circuit may sense the capacitance change to detect a touch coordinate.

In the non-active area NA of the display apparatus 1000, a touch line and a touch driving circuit may be disposed. The touch line may be disposed in the first non-bending area NBA1 and the touch driving circuit may be disposed in the second non-bending area NBA2. The touch line and the touch driving circuit may be electrically connected by the connection line 116. For example, one end of the connection line 116 may be connected to a touch line and the other end of the connection line 116 may be connected to a touch driving circuit.

Each of a first touch block Rx and a second touch block Tx may be electrically connected to the corresponding touch line 760.

The touch line 760 may include a first touch line 761 and a second touch line 762. The first touch line 761 may be electrically connected to the first touch block Rx and the second touch line 762 may be electrically connected to the second touch block Tx.

Each of the first touch block Rx and the second touch block Tx may be connected to the touch driving circuit TDC disposed in a part of the first non-active area NA1 by the first touch line 761 and the second touch line 762. Each of the first touch block Rx and the second touch block Tx is connected to the touch driving circuit TDC to transmit or receive signals.

The touch driving circuit TDC may receive a touch sensing signal from the first touch block Rx or the first touch electrode 740_R. Further, the touch driving circuit TDC may transmit a touch driving signal to the second touch block Tx or the second touch electrode. The touch driving circuit TDC may sense the user's touch using mutual capacitance between the first touch block Rx and the second touch block Tx. For example, when the touch operation is performed on the display apparatus 1000, a capacitance between the first touch block Rx and the second touch block Tx may be changed. The touch driving circuit TDC may sense the capacitance change to detect a touch coordinate.

A cover layer 800 may be disposed on the third protection layer 750.

The cover layer 800 may further planarize an area which is not partially planarized by the third protection layer 750. Alternatively, the cover layer 800 may effectively block moisture and oxygen entering from the outside of the display apparatus. The cover layer 800 may be a fourth encapsulation layer, but the exemplary embodiments of the present disclosure are not limited thereto.

The cover layer 800 may be an organic material, for example, a polymer such as silicon oxy carbon (SiOCz), epoxy, polyimide, polyethylene, or acrylate, but is not limited thereto. The cover layer 800 may be formed of a thermosetting material or a photo curable material which is hardened by heat or light.

The cover layer 800 may be configured with the same material as a material which configures the second encapsulation layer 620.

The cover layer 800 may be formed by various methods such as inkjet coating or slit coating. For example, the cover layer 800 may be formed on the third protection layer 750 by spraying or dropping a liquid organic material on the substrate 110 on which the third protection layer 750 is formed, in the active area AA using an inkjet device or a nozzle coating device. A fluid organic material may be formed in an applying area while the spraying nozzle moves on the applying area (or a nozzle is fixed and a subject moves).

A material which configures the cover layer 800 has a low viscosity characteristic so that it may be in a liquid state a having a high density until the material is hardened. A partition 1300 may be disposed in a non-active area adjacent to the bending area to solve the problem that the cover layer 800 spreads (or flows) to the bending area BA. The partition 1300 will be described in detail with reference to FIG. 8.

Referring to FIG. 8, the cover layer 800 may extend to the bending area BA and the second non-bending area NBA2.

Hereinafter, the partition will be described in detail with reference to FIG. 8.

FIG. 8 is a cross-sectional view taken along the line III-III' of FIG. 5 according to an exemplary embodiment of the present disclosure. FIG. 8 is a view illustrating a non-active area NA which illustrates a part of the bending area BA.

Referring to FIG. 8, the partition 1300 may be disposed in the second non-bending area NBA2.

In a part adjacent to the active area AA, a plurality of insulating layers, a protection layer, an encapsulation layer, and a cover layer disposed in the active area AA may extend to be disposed to the first non-active area NA1.

On the substrate 110, a first insulating layer 120, a second insulating layer 130, a third insulating layer 140, a fourth insulating layer 150, a fifth insulating layer 160, a first protection layer 171, a second protection layer 172, a fourth protection layer 521, a fifth protection layer 531, a first encapsulation layer 610, a second encapsulation layer 620, a third encapsulation layer 630, a buffer layer 710, an insulating layer 730, a third protection layer 750, and a cover layer 800 may be sequentially disposed.

The fourth protection layer 521 may be formed of the same material as the bank 520 of the active area AA and may be formed simultaneously with the bank 520, or formed by a separate process. The fourth protection layer 521 may be formed of at least one or more materials among inorganic insulating materials, such as silicon nitride (SiNx) or silicon oxide (SiOx), organic insulating materials, such as benzocyclobutene (BCB), acrylic resin, epoxy resin, phenolic resin, polyamide resin, or polyimide resin, or photosensitizers including a black pigment, but is not limited thereto. The fourth protection layer 521 may be formed to be transparent or black or colored.

The fifth protection layer 531 may be formed of the same material as the spacer 530 of the active area AA and may be formed simultaneously with the spacer 530, or formed by a separate process. The fifth protection layer 531 may be formed of at least one or more materials among inorganic insulating materials, such as silicon nitride (SiNx) or silicon oxide (SiOx), organic insulating materials, such as benzocyclobutene (BCB), acrylic resin, epoxy resin, phenolic resin, polyamide resin, or polyimide resin, or photosensitizers including a black pigment, but is not limited thereto. The fifth protection layer 531 may be formed to be transparent or black or colored.

A protection layer is etched to dispose the dam 117 in a part of the first non-active area NA1. For example, the first protection layer 171, the second protection layer 172, the fourth protection layer 521, and/or the fifth protection layer 531 are etched and the dam 117 may be disposed on the insulating layer or the fifth insulating layer 160.

The dam 117 may suppress the second encapsulation layer 620 formed of an organic material from overflowing to the driving element during the process before being cured. The second encapsulation layer 620 may be in contact with the dam 117.

The number of dams 117 may be one or plural and when a plurality of dams 117 is configured, the second encapsulation layer 620 may be partially formed between the plurality of dams.

The dam 117 may be disposed as a plurality of layers using at least one material. For example, the dam 117 is formed as a plurality of layers, the dam 117 may include a first dam 117a, a second dam 117b, and a third dam 117c.

The first dam 117a may be formed of the same material as at least one of the first protection layer 171 and the second protection layer 172 and may be formed simultaneously with the protection layer 170 or formed by a separate process.

The second dam 117b may be formed of the same material as the bank 520 and/or the fourth protection layer 521 and may be simultaneously formed with the bank 520 and/or the fourth protection layer 521, or formed by a separate process.

The third dam 117c may be formed of the same material as the spacer 530 and/or the fifth protection layer 531 and may be formed simultaneously with the spacer 530 and/or the fifth protection layer 531, or formed by a separate process.

The fourth protection layer 521 and the fifth protection layer 531 may be simultaneously formed, but are not limited thereto.

An encapsulation unit 600 may be disposed on the substrate 110 on which the dam 117 is disposed. The first encapsulation layer 610 is disposed on the insulating layer, the protection layer, and/or the dam 117 disposed below the first encapsulation layer 610 and may extend to the bending area BA while covering the dam 117.

The second encapsulation layer 620 may be disposed on the first encapsulation layer 610 and may be in contact with the dam 117.

A third encapsulation layer 630 may be disposed on the second encapsulation layer 620 and the dam 117. The third encapsulation layer 630 is disposed on the insulating layer, the protection layer, and/or the dam 117 disposed below the third encapsulation layer 630 and may extend to the bending area BA while covering the first encapsulation layer 610 and the dam 117. The first encapsulation layer 610 and the third encapsulation layer 630 may be in contact with each other.

A touch line 760 which is electrically connected to the touch driving circuit TDC, and the first touch block Rx and the second touch block Tx of the touch unit 700 to transmit or receive signals may be disposed on the encapsulation unit 600.

The touch line 760 may be electrically connected to the touch driving circuit TDC through the connection line 116. The touch line 760 and the connection line 116 may be in contact with each other by etching some insulating layer or protection layer between the active area AA and the bending area BA. For example, the touch line 760 and the connection line 116 may be in contact with each other between the dam 117 and a partition 1300.

The third protection layer 750 may be disposed on the touch line 760.

According to the exemplary embodiment of the present disclosure, the insulating layer 730 is configured with an organic material so that the third protection layer 750 configured with the organic material may be omitted.

The cover layer 800 may be disposed on the third protection layer 750. A material which configures the cover layer 800 has a low viscosity characteristic so that it may be in a liquid state having a high density until the material is hardened. A partition 1300 may be disposed in a non-active area adjacent to the bending area to solve the problem that the cover layer 800 spreads (or flows) to the bending area BA. The cover layer may cover the touch unit and the touch line.

The partition 1300 may be disposed in a part of the bending area BA to control the flow of the cover layer 800 which includes an organic material. The number of partitions 1300 may be one or more or plural. When a plurality of partitions 1300 is configured, the partitions may include a first partition 1310 and a second partition 1320.

A part of the third protection layer 750 may be disposed around the partition 1300. The third protection layer 750 disposed in the second non-bending area NBA2 may be simultaneously formed when the third protection layer 750 is formed in the first non-bending area NBA1 to protect the connection line 116 and/or the touch line 760 disposed in the non-bending area NBA.

The cover layer 800 may be partially disposed between the first partition 1310 and the second partition 1320. Further, the cover layer 800 may be partially disposed between the third protection layer 750 and the partition 1300.

Further, the partition 1300 may be disposed as a plurality of layers using at least one or more materials. For example, the partition 1300 may be formed of the same material as the third protection layer 750.

The partition 1300 may be formed simultaneously with the third protection layer 750 or formed by a separate process.

The display apparatus 1000 includes the cover layer 800 and the partition 1300 so that the problems of the crack or the short-circuit of the wiring line caused by the mechanical stress in the bending area during the bending process of the substrate 110 or after the bending process may be avoided.

The display apparatus according to the exemplary embodiment of the present disclosure may be applicable to a mobile device, a video phone, a smart watch, a watch phone, a wearable apparatus, a foldable apparatus, a rollable apparatus, a bendable apparatus, a flexible apparatus, a curved apparatus, a sliding apparatus, a variable apparatus, an electronic note, an electronic book, a portable multimedia player (PMP), a personal digital assistant (PDA), an MP3 player, a mobile medical apparatus, a desktop PC, a laptop PC, a netbook computer, a workstation, a navigation, a navigation for a vehicle, a display apparatus for a vehicle, an apparatus for a vehicle, a theatrical device, a theatrical display device, a television, a wallpaper device, a signage device, a game device, a notebook, a monitor, a camera, a camcorder, and a consumer electronics device. Further, the display apparatus according to one or more exemplary embodiments of the present disclosure may also be applied to an organic light emitting illumination device or an inorganic light emitting illumination device.

Although the exemplary embodiments of the present disclosure have been described in detail with reference to the accompanying drawings, the present disclosure is not limited to the exemplary embodiments and may be modified in various forms without departing from the technical concept of the present disclosure. Therefore, the exemplary embodiments of the present disclosure are provided for illustrative purposes only but not intended to limit the technical spirit of the present disclosure. The scope of the technical spirit of the present disclosure is not limited thereto. Therefore, it should be understood that the above-described exemplary embodiments are illustrative in all aspects and do not limit the present disclosure.

## Claims

1. A display apparatus, comprising:
a substrate (110) which includes a first non-bending area (NBA1), a second non-bending area (NBA2), and a bending area (BA) disposed between the first non-bending area (NBA1) and the second non-bending area (NBA2);
a light emitting diode layer (500) disposed in the first non-bending area (NBA1) on the substrate (110);
a cover layer (800) disposed in the first non-bending area (NBA1), the bending area (BA); and at least on a partial area of the second non bending area (NBA2),
a partition (1300) disposed in the second non-bending area on the substrate.

2. The display apparatus according to claim 1, wherein the cover layer (800) is disposed in the first non-bending area (NBA1), the bending area (BA), and a partial area of the second non-bending area (NBA2), the cover layer (800) being disposed over the light emitting element layer (500).

3. The display apparatus according to claim 1 or 2, wherein a transistor (300) and the light emitting diode layer (500) are disposed in the first non-bending area (NBA1) on the substrate (110).

4. The display apparatus according to any one of the preceding claims, wherein the partition (1300) includes a first partition (1310) and a second partition (1320) spaced apart from each other.

5. The display apparatus according to any one of the preceding claims, wherein the cover layer (800) is disposed in a partial area of the second non-bending area (NBA2) adjacent to the bending area (BA), and is not disposed in other areas of the second non-bending area (NBA2) excluding the partial area.

6. The display apparatus according to any one of the preceding claims, wherein the cover layer (800) is continuously disposed in the first non-bending area (NBA1), the second non-bending area (NBA2), and the bending area (BA) and/or the cover layer (800) is in contact with one surface of the partition (1300).

7. The display apparatus according to any one of the preceding claims, further comprising:
a touch unit (700) disposed over the light emitting diode layer (500); and
a protection layer (750) disposed on the touch unit (700),
wherein the cover layer (800) is disposed on the protection layer (750).

8. The display apparatus according to claim 7, the touch unit (700) includes a touch line (760), and the cover layer (800) is in contact with the touch line (760) in the second non-bending area (NBA2).

9. The display apparatus according to any one of the preceding claims 3-8, further comprising a second protection layer (170) disposed between the transistor (300) and the light emitting diode layer (500),
wherein the second protection layer (170) includes a first sub protection layer (171) and a second sub protection layer (172), wherein a connection line (116) connecting to the touch line (760) is disposed between the first sub protection layer (171) and the second sub protection layer (172).

10. The display apparatus according to any one of the preceding claims 7-9, an end of the cover layer (800) in the second non-bending area (NBA2) is disposed between the protection layer (750) and the partition (1300).

11. The display apparatus according to any one of the preceding claims 7-10, wherein the partition (1300) is configured on the same layer as the protection layer (750).

12. The display apparatus according to any one of the preceding claims, further comprising a dam (117) disposed on the first non-bending area (NBA1), preferably the partition (1300) is spaced apart from the dam (117) by the bending area (BA).

13. The display apparatus according to any one of the preceding claims 3-12, further comprising:
a second protection layer (170) and a bank (520) disposed between the transistor (300) and the light emitting diode layer (500); and
a spacer (530) disposed on the bank (520).

14. The display apparatus according to claim 12 or 13, wherein the dam (117) is configured with the same material as at least one or more of materials which configure the spacer (530), the bank (520), and the protection layer (170, 750).

15. The display apparatus according to any one of the preceding claims 9-14, wherein the cover layer (800) is in contact with the second protection layer (170) in the bending area (BA).
